# EUROPEAN PATENT APPLICATION

(11) **EP 2 910 407 A2**
(43) Date of publication of application: **26.08.2015**
(21) Application number: 15151883.4
(22) Date of filing: 21.01.2015
(51) Int. Cl.: B60L 11/18

(54) **Connection detecting device for electric vehicle charger**

(30) Priority: 28.01.2014 KR 20140010532
(71) Applicant: LSIS Co., Ltd., Anyang-si, Gyeonggi-do 431-848 (KR)
(72) Inventor: Jin, Ho Sang, 431-848 Anyang-si, Gyeonggi-do (KR); Park, Hong Tae, 431-848 Anyang-si, Gyeonggi-do (KR); Lee, Jae Ho, 431-848 Anyang-si, Gyeonggi-do (KR); Park, Chan Gi, 431-848 Anyang-si, Gyeonggi-do (KR)
(74) Representative: Lang, Johannes

(57) **Abstract**

A connection detecting device for an electric vehicle charger, which detects whether the charger for a vehicle is connected to the electric vehicle, is provided. The connection detecting device includes a connection unit connecting a coupler of the charger for the vehicle to the electric vehicle, a power supply unit supplying a voltage to the connection unit when being turned on, a first signal generation unit generating a first signal to turn on the power supply unit when the charger for the vehicle is connected to the electric vehicle, and a control unit determining whether the charger for the vehicle is connected to the electric vehicle on the basis of the voltage applied to the connection unit. The first signal generation unit is an open circuit through which a current does not flow, when the charger for the vehicle is disconnected from the electric vehicle.

## Description

### BACKGROUND

The present disclosure relates to a connection detecting device for an electric vehicle charger.

Electric vehicles mean vehicles driven by using electricity. Electric vehicles may be largely classified into battery powered electric vehicles and hybrid electric vehicles. Here, the battery powered electric vehicles mean vehicles driven by using only electricity without using fossil fuel, and are thus generally called an electric vehicle. The hybrid electric vehicles mean vehicles driven by using electricity and fossil fuel. These electric vehicles include a battery for supplying electricity for traveling. In particular, a battery powered electric vehicle and a plug-in type hybrid electric vehicle use power supplied from an external power supply to charge batteries, and use the power charged in the battery to drive an electric motor. Thus, the electric vehicles need to be charged to be driven.

The electric vehicle is charged through a charge station for electric vehicle and a vehicle charger. The charger station for electric vehicle suppllies power to the vehicle charger. The vehicle charger supplies power to the electric vehicle. Here, the charger for the electric vehicle is connected to the electric vehicle through a charging coupler of the charger for the electric vehicle. When the charging coupler of the vehicle charger is connected, the electric vehicle starts a charging operation. In detail, the electric vehicle activates a charge device in the electric vehicle. Also, when the charging coupler of the vehicle charger is disconnected, the electric vehicle stops the charging operation. In detail, the electric vehicle deactivates the charge device in the electric vehicle. Thus, the electric vehicle needs a device of detecting the connection of the charging coupler of the vehicle charger.

In the present disclosure, a connection detecting device for an electric vehicle charger, which detects connection between the vehicle charger and a charging coupler is provided. In particular, the present disclosure provides a connection detecting device for an electric vehicle charger, which detects connection between the vehicle charger and a charging coupler and minimizes power loss.

### SUMMARY

Embodiments provide a connection detecting device for an electric vehicle charger, which detects connection between the vehicle charger and a charging coupler and minimizes power loss.

In one embodiment, a connection detecting device for an electric vehicle charger, which detects whether the vehicle charger is connected to the electric vehicle, includes: a connection unit connecting a coupler of the vehicle charger to the electric vehicle; a power supply unit supplying a voltage to the connection unit when being turned on; a first signal generation unit generating a first signal to turn on the power supply unit when the vehicle charger is connected to the electric vehicle; and a control unit determining whether the vehicle charger is connected to the electric vehicle on the basis of the voltage applied to the connection unit, wherein the first signal generation unit is an open circuit through which a current does not flow, when the vehicle charger is disconnected from the electric vehicle.

The first signal generation unit may include an optoisolator, and when the vehicle charger is connected to the electric vehicle, the first signal generation unit allows the current to flow into a light emitting diode (LED) of the optoisolator to generate the first signal.

When the voltage applied into the connection unit has a higher level than a first reference voltage, the control unit may determine that the vehicle charger is connected to the electric vehicle.

The control unit may determine whether the vehicle charger is disconnected from the electric vehicle on the basis of the voltage applied to the connection unit, and wherein the device may further include a signal generation unit generating a second signal to turn off the power supply unit when the vehicle charger is disconnected from the electric vehicle.

When the voltage applied to the connection unit has a higher level than the second reference voltage, the control unit may determine that the vehicle charger is disconnected from the electric vehicle, the second reference voltage being greater than the first reference voltage.

In another embodiment, a method of operating a connection detecting device for an electric vehicle charger, which detects whether the vehicle charger is connected to the electric vehicle, includes: determining whether the vehicle charger is connected to the electric vehicle on the basis of a voltage applied to a connection unit which connects a coupler of the vehicle charger to the electric vehicle; and generating a first signal through a first signal generation unit to turn on a power supply unit for supplying the voltage to the connection unit, when the vehicle charger is connected to the electric vehicle, wherein the first signal generation unit is an open circuit in which a current does not flow when the vehicle charger is disconnected from the electric vehicle.

The details of one or more embodiments are set forth in the accompanying drawings and the description below. Other features will be apparent from the description and drawings, and from the claims.

### BRIEF DESCRIPTION OF THE DRAWINGS

Fig. 1 is a block diagram of a connection detecting device for an electric vehicle charger according to an embodiment.
Fig. 2 is a circuit diagram of the connection detecting device for the electric vehicle charger according to an embodiment.
Fig. 3 is an operation flowchart of the connection detecting device for the electric vehicle charger according to an embodiment.
Fig. 4 is a block diagram of a connection detecting device for an electric vehicle charger according to another embodiment.
Fig. 5 is a circuit diagram of the connection detecting device for the electric vehicle charger according to another embodiment.
Fig. 6 is an operation flowchart of the connection detecting device for the electric vehicle charger according to another embodiment.

### DETAILED DESCRIPTION OF THE EMBODIMENTS

Hereinafter, preferred embodiments of the present invention will be described in detail with reference to the accompanying drawings in such a manner that the technical idea of the present invention may easily be carried out by a person with ordinary skill in the art to which the invention pertains. The present invention may, however, be embodied in different forms and should not be construed as limited to the embodiments set forth herein. In the drawings, anything unnecessary for describing the present disclosure will be omitted for clarity, and also like reference numerals in the drawings denote like elements.

Furthermore, when it is described that one comprises (or includes or has) some elements, it should be understood that it may comprise (or include or has) only those elements, or it may comprise (or include or have) other elements as well as those elements if there is no specific limitation.

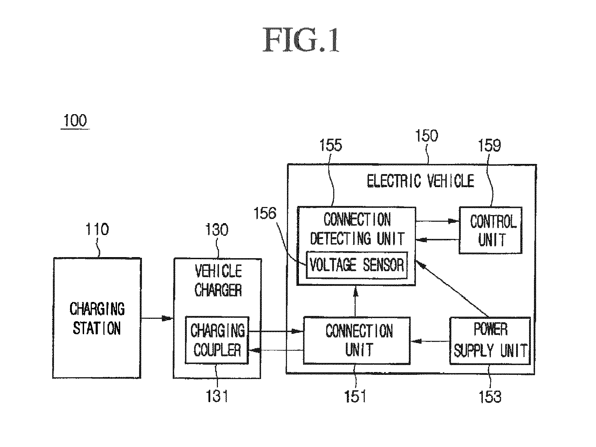

Hereinafter, a connection detecting device for an electric vehicle charger according to an embodiment will be described with reference to Figs. 1 to 3.

Fig. 1 is a block diagram of a connection detecting device for an electric vehicle charger according to an embodiment.

Referring to Fig. 1, a connection detecting device for an electric vehicle charger 100 includes a charging station 110, a charger 130 for a vehicle, and an electric vehicle 150.

The charging station 110 supplies power to the charger 130 for the vehicle.

The charger 130 for the vehicle transmits the power to the electric vehicle 150. The charger 130 for the vehicle includes a charging coupler 131. The charging coupler 131 connects the charger 130 for the vehicle to the electric vehicle 150.

The electric vehicle 150 includes a connection unit 151, a power supply unit 153, a connection detecting unit 155, and a control unit 159. The connection detecting unit 155 connects the electric vehicle 150 to the charging coupler 131 of the charger 130 for the vehicle. The power supply unit 153 supplies the power to the connection detecting unit 155.

The power supply unit 153 may include a battery (not shown) and a regulator (not shown). Here, the power supply unit 153 may use the regulator to convert a voltage level of the power supplied from the battery into a voltage level required for the connection detecting unit 155 and supply the power with the voltage level converted. Here, the voltage level required for the connection detecting unit 155 may be about 5 V.

The connection detecting unit 155 detects whether the connection unit 151 of the electric vehicle 150 is connected to the charging coupler 131 of the charger 130 for the vehicle. Here, the connection detecting unit 155 may generate a signal indicating connection or disconnection and transmit the signal to the control unit 159. The connection detecting unit 155 includes a voltage sensor 156. The voltage sensor 156 detects a level of a voltage applied to the connection unit 151.

The control unit 159 controls an operation of the electric vehicle 150. In particular, the control unit 159 controls an operation of the electric vehicle 150, which is required to charge the electric vehicle 150. In detail, the control unit 159 may control an internal charging device (not shown) to be activated or deactivated.

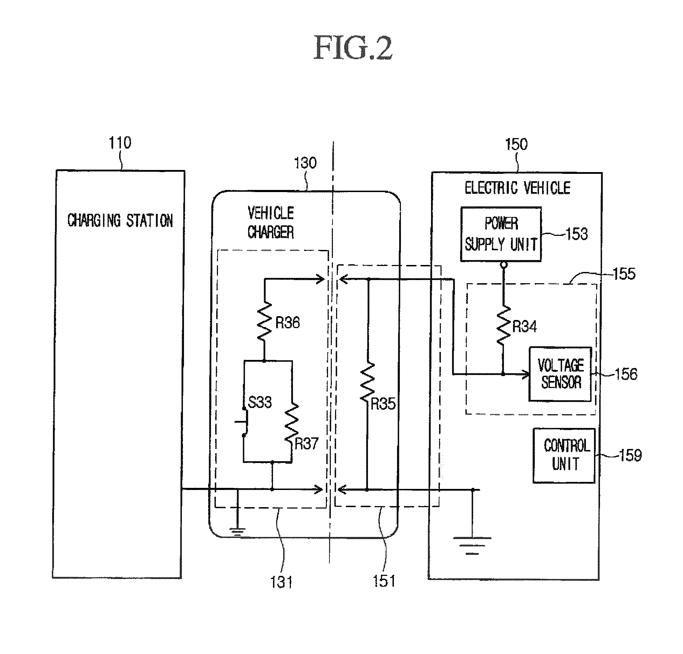

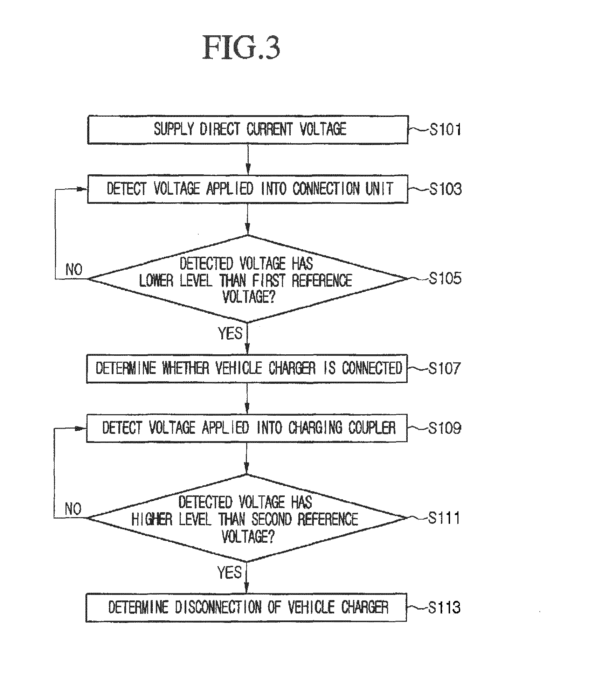

Operations of the connection detecting device for the electric vehicle charger according to an embodiment will be described with reference to Figs. 2 and 3 in detail.

Fig. 2 is a circuit diagram of the connection detecting device for the electric vehicle charger according to an embodiment.

The charging coupler 131 includes a switch S33, a resistor R36, and a resistor R37. One end of the switch S33 is grounded. One end of the resistor R36 is connected to the other end of the switch S33. The resistor R37 has one end connected to the one end of the resistor R36, and the other end that is grounded. When the charging coupler 131 is connected to the connection unit 151 of the electric vehicle 150, the other end of the resistor R36 is connected to one end of the connection unit 151 of the electric vehicle 150. Here, a direct current (DC) voltage is applied to the one end of the resistor R36 and the other end of the resistor R37.

The connection unit 151 includes a resistor R35. One end of the resistor R35 is grounded. When the charging coupler 131 is connected to the connection unit 151 of the electric vehicle 150, the other end of the resistor R35 is connected to one end of the charger 130 for the vehicle. A DC voltage generated from the power supply unit 153 is applied to the resistor R35. When the charging coupler 131 is connected to the connection unit 151 of the electric vehicle 150, the resistor R35 is connected to the charging coupler 131 of the charger 130 for the vehicle, and thus the voltage is divided. In detail, when the charging coupler 131 is connected to the connection unit 151 of the electric vehicle 150, the resistor R35 is parallelly connected to a combined resistor of the resistor R36 and the resistor R37. The resistance of a combined resistor in which the resistor R35 is parallelly connected to a combined resistor of the resistor R35 and the resistor R37 is as follows: (resistance of the resistor R35+resistance of the resistor R36+resistance of the resistor R37)/(resistance of the resistor R35) X (resistance of the resistor R36+resistance of the resistor R37)). Thus, the resistance of the combined resistor in which the resistor R35 is parallelly connected to the combined resistor of the resistor R36 and the resistor R37 is less than that of the resistor R35. Therefore, according to the voltage divider rule, a level of the DC voltage applied to the one end of the resistor R35 becomes lower than that of the case where the charging coupler 131 is not connected to the connection unit 151 of the electric vehicle 150.

The connection detecting unit 155 includes a resistor R34 and a voltage sensor 156. One end of the voltage sensor 156 of the connection detecting unit 155 is connected to the other end of the resistor R35 of the connection unit 151. The resistor R34 of the connection detecting unit 155 has one end connected to the voltage sensor 156 and the other end connected to the power supply unit 153. The voltage sensor 156 detects a DC voltage applied to the one end of the resistor R35 of the connection unit 151 to output the DC voltage with a certain voltage level. A DC voltage supplied from the power supply unit 153 is applied to the other end of the resistor R34.

The control unit 159 is connected to the other end of the voltage sensor 156. The control unit 159 may determine whether the charging coupler 131 of the charger 130 for the vehicle is connected to the connection unit 151 of the electric vehicle 150 on the basis of a level of the DC voltage outputted from the voltage sensor 156. In detail, when the DC voltage outputted from the voltage sensor 156 has a lower level than a first reference voltage, the control unit 159 may determine that the charging coupler 131 is connected to the connection unit 151 of the electric vehicle 150. Also, when the DC voltage outputted from the voltage sensor 156 has a higher level than a second reference voltage, the control unit 159 may determine that the charging coupler 131 of the charger 130 for the vehicle is disconnected from the connection unit 151 of the electric vehicle 150. Here, the second reference voltage has a higher level than the first reference voltage and a lower level than the voltage supplied from the power supply unit 153. This is because the level of the DC voltage applied to the one end of the resistor R35 of the connection unit 151 varies according to whether the charging coupler 131 of the charger 130 for the vehicle is connected to the connection unit 151 of the electric vehicle 150. According to an alternative embodiment, the control unit 159 may include the voltage sensor 156.

Fig. 3 is an operation flowchart of the connection detecting device for the electric vehicle charger according to an embodiment.

In operation S101, the power supply unit 153 supplies the DC voltage. The power supply unit 153 may include the battery (not shown) and the regulator (not shown). Here, the power supply unit 153 may use the regulator to convert a voltage level of the power supplied from the battery into a voltage level required for the connection detecting unit 155 and supply the power with the voltage level converted. Here, the voltage level required for the connection detecting unit 155 may be about 5 V. Here, the DC voltage is applied to the connection unit 151. In detail, the DC voltage is applied to the resistor R35 of the connection unit 151.

In operation S103, the connection detecting unit 155 detects the voltage applied into the connection unit 151 through the voltage sensor 156.

Here, the control unit 159 may determine that the charger 130 for the vehicle is connected to the electric vehicle 150 on the basis of the level of the detected voltage. In detail, the control unit 159 may determine connection through steps as described below. As described above, this is because the level of the DC voltage applied to the one end of the resistor R35 of the connection unit 151 varies according to whether the charging coupler 131 of the charger 130 for the vehicle is connected to the connection unit 151 of the electric vehicle 150.

In operation S105, the control unit 159 determines whether the detected voltage has a lower level than the first reference voltage.

In operation S107, when the detected voltage has a lower level than the first reference voltage, the control unit 159 may determine that the charger 130 for the vehicle is connected to the electric vehicle 150. As described above, this is because the level of the DC voltage applied to the one end of the resistor R35 of the connection unit 151 becomes lower as the charging coupler 131 of the charger 130 for the vehicle is connected to the connection unit 151 of the electric vehicle 150. In detail, the control unit 159 may determine that the charging coupler 131 of the charger 130 for the vehicle is connected to the connection unit 151 of the electric vehicle 150. Here, the control unit 159 may perform an operation for charging the electric vehicle 150. In detail, the control unit 159 may activate the charging device in the electric vehicle 150.

In operation S109, the connection detecting unit 155 detects the voltage applied to the connection unit 151 through the voltage sensor 156.

In operation S111, the control unit 159 determines whether the level of the detected voltage is greater than that of the second reference voltage.

In operation S113, when the level of the detected voltage is less than that of the first reference voltage, the control unit 159 may determine that the charger 130 for the vehicle is disconnected from the electric vehicle 150. As described above, this is because the level of the DC voltage applied to the one end of the resistor R35 of the connection unit 151 becomes higher as the charging coupler 131 of the charger 130 for the vehicle is disconnected from the connection unit 151 of the electric vehicle 150. In detail, the control unit 159 may determine that the charging coupler 131 of the charger 130 for the vehicle is disconnected from the connection unit 151 of the electric vehicle 150. Here, the control unit 159 may perform an operation for stopping the charging of the electric vehicle 150. In detail, the control unit 159 may deactivate the charging device in the electric vehicle 150.

As described above, in the connection detecting device for the electric vehicle charger according to an embodiment, the DC voltage is applied to the connection unit 151 even though the electric vehicle 150 is not connected to the charger 130 for the vehicle. Thus, even when the electric vehicle 150 is not connected to the charger 130 for the vehicle, the connection detecting device for the electric vehicle charger consumes DC power at all times. Since the battery of the electric vehicle 150 has a limitation in charge capacity and requires a long time for charging, there is a need to minimize power consumption. Also, most of the automobile manufacturers settle the standard of dark current consumption in the charger for the electric vehicle is 100 uA or less. Thus, when considering this fact, there is a need for a connection detecting device for an electric vehicle charger, which detects connection of a charger coupler of a vehicle charger and minimize power loss.

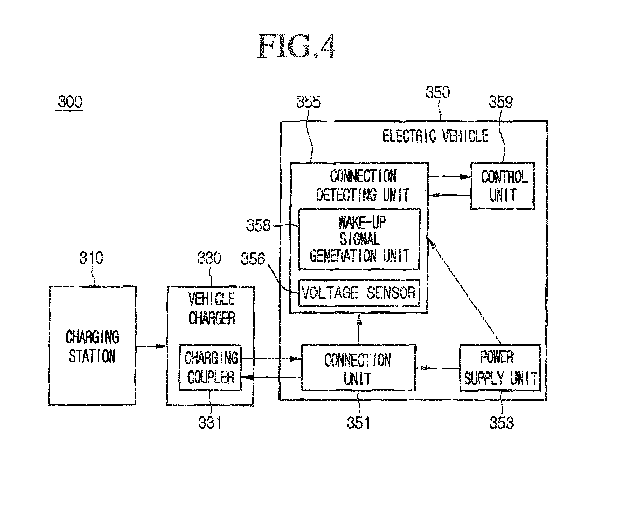

Fig. 4 is a block diagram of a connection detecting device for an electric vehicle charger according to another embodiment.

Referring to Fig. 4, a connection detecting device for an electric vehicle charger 300 includes a charging station 310, a vehicle charger 330, and an electric vehicle 350.

The charging station 310 supplies power to the vehicle charger 330.

The vehicle charger 330 supplies the power to the electric vehicle 350. The vehicle charger 330 includes a charging coupler 331. The charging coupler 331 connects the vehicle charger 330 to the electric vehicle 350.

The electric vehicle 350 includes a connection unit 351, a power supply unit 353, a connection detecting unit 355, and a control unit 359. The connection detecting unit 351 connects the electric vehicle 350 to the charging coupler 330 of the vehicle charger 331.

The power supply unit 353 supplies the power to the connection detecting unit 355. The power supply unit 353 may include a battery (not shown) and a regulator (not shown). Here, the power supply unit 353 may use the regulator to convert a voltage level of the power supplied from the battery into a voltage level required for the connection detecting unit 355 and supply the power with the voltage level converted. Here, the DC voltage supplied from the battery has a lower level than the DC voltage supplied from the regulator (5V_PROX_REGULATOR1) of the power supply unit 353. In particular, when the power supply unit 353 receives a wake-up signal from the connection detecting unit 355, the power supply unit 353 uses the regulator to convert the voltage level of the power supplied from the battery into a voltage level required for the connection detecting unit 355 and then supply the power with the voltage level converted. Here, the wake-up signal is a signal indicating that the electric vehicle 350 is connected to the vehicle charger 330. When the power supply unit 353 receives a sleep signal from the control unit 359, the power supply unit 353 turns off the regulator (5V_PROX_REGULATOR1). Here, the sleep signal is a signal indicating that the electric vehicle 350 is disconnected from the vehicle charger 330. Here, the voltage level required for the connection detecting unit 355 may be about 5 V.

The connection detecting unit 355 detects whether the connection unit 350 of the electric vehicle 351 is connected to the charging coupler 330 of the vehicle charger 331. Here, the connection detecting unit 355 may generate a signal indicating connection or disconnection to transmit the signal to the control unit 359. The connection detecting unit 355 includes a voltage sensor 356 and a wake-up signal generation unit 356. The voltage sensor 356 detects a level of the voltage applied into the connection unit 351. When the connection unit 351 of the electric vehicle 350 is connected to the charging coupler 331 of the vehicle charger 330, the wake-up signal generation unit 358 generates the wake-up signal to transmit the wake-up signal to the power supply unit 353.

The control unit 359 controls an operation of the electric vehicle 350. In particular, the control unit 359 controls an operation of the electric vehicle 350, which is required to charge the electric vehicle 150. In detail, the control unit 159 may control an internal charging device (not shown) to be activated or deactivated. Also, the control unit 359 may generate the sleep signal on the basis of a voltage outputted from the voltage sensor 356 to transmit the sleep signal to the power supply unit 353.

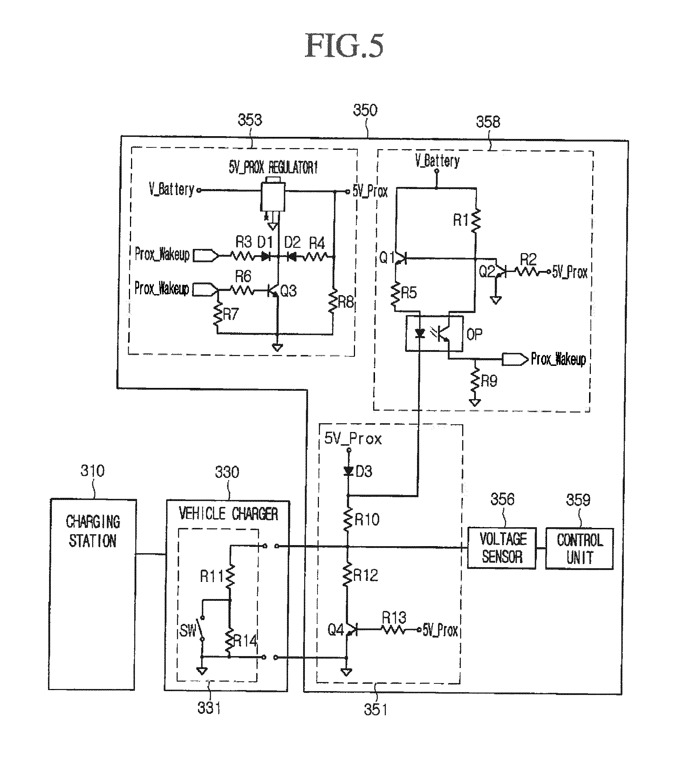

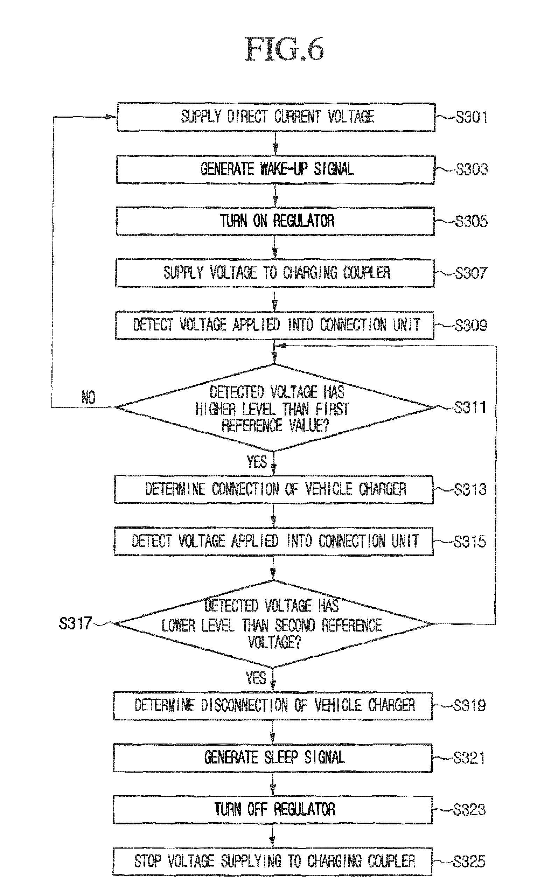

Operations of the connection detecting device for the electric vehicle charger according to an embodiment will be described with reference to Figs. 5 and 6 in detail.

Fig. 5 is a circuit diagram of the connection detecting device for the electric vehicle charger according to another embodiment.

The charging coupler 331 includes a switch SW, a resistor R14, and a resistor R13. One end of the switch S33 is grounded. One end of the resistor R11 is connected to the other end of the switch SW. The resistor R14 has one end connected to the one end of the resistor R11, and the other end that is grounded. When the charging coupler 331 is connected to the connection unit 350 of the electric vehicle 351, the other end of the resistor R11 is connected to one end of the connection unit 350 of the electric vehicle 351. Here, a DC voltage is applied to the one end of the resistor R14 and the other end of the resistor R11.

The connection unit 351 includes a bipolar junction transistor (BJT) Q4, a resistor R12, a resistor R10, a resistor R13, and a diode D3. One end of the resistor R13 is connected to a voltage terminal 5V_Prox through which the power supplied from the regulator 5V_PROX_REGULATOR of the power supply unit 353 is outputted. Here, a level of the voltage supplied to the voltage terminal 5V_Prox may be about 5 V. A base terminal of the BJT Q4 is connected to the other end of the resistor R13 and an emitter terminal of the BJT Q4 is grounded. The resistor R12 has one end that is connected to a collector terminal of the BJT Q4 and the other end that is connected to one end of the charging coupler 331 of the vehicle charger 330 when the vehicle charger 330 is connected to the electric vehicle 350. One end of the resistor R10 is connected to the other end of the resistor R12. An anode terminal of the diode D3 is connected to the other end of the resistor R10, and a cathode terminal of the diode D3 is connected to the voltage terminal 5V_Prox through which the output voltage of the regulator 5V_PROX_REGULATOR is outputted.

The voltage sensor 356 is connected to the one end of the resistor R12 and the control unit 359.

The wake-up signal generation unit 358 includes a BJT Q1, a BJT Q3, a resistor R1, a resistor R2, a resistor R5, a resistor R9, and an optoisolator OP. The optoisolator OP acts to modulate data into optical beam so as to electrically insulate a system. Since the optoisolator OP prevents the system from being electrically connected, power loss may be minimized. The optoisolator OP includes a light emitting diode (LED) and a photo transistor. One end of the resistor R2 is connected to a voltage terminal 5V_Prox through which an output voltage of the regulator 5V_PROX_REGULATOR is outputted. A base terminal of the BJT Q2 is connected to the other end of the resistor R2 and an emitter terminal of the BJT Q2 is grounded. The resistor R1 has one end that is connected to a collector terminal of the BJT Q2 and the other end that is connected to a voltage terminal V_Battery through which a voltage of a battery is outputted. A collector terminal of the BJT Q1 is connected to the voltage terminal V_Battery through which the voltage of the battery is outputted, and a base terminal of the BJT Q1 is connected to the one end of the resistor R1. One end of the resistor R5 is connected to an emitter terminal of the BJT Q1. An anode terminal of the LED of the optoisolator OP is connected to the other end of the resistor R5. A collector terminal of the photo transistor of the optoisolator OP is connected to the one end of the resistor R1, and a base terminal of the optoisolator OP is connected to the LED. The resistor R9 has one end that is connected to an emitter terminal of the optoisolator OP and to a voltage terminal Prox_Wakeup inputting a wake-up signal, and the other end that is grounded.

The power supply unit 353 includes a battery (not shown), a regulator 5V_PROX_REGULATOR1, a resistor R3, a resistor R4, a resistor R6, a resistor R7, a resistor R8, a BJT Q3, a diode D1, and a diode D2. An input part of the regulator 5V_PROX_REGULATOR1 is connected to a voltage terminal to which a voltage is inputted from the battery, and an output part of the regulator 5V_PROX_REGULATOR1 is connected to a voltage terminal 5v_Prox through which the voltage is outputted. One end of the resistor R3 is connected to a voltage terminal Prox_Wakeup through which a voltage of a wake-up signal is outputted. The diode D1 has an anode terminal connected to the other end of the resistor R3, and a cathode terminal connected to an on/off terminal of the regulator 5V_PROX_REGULATOR. One end of the resistor R4 is connected to the output part of the regulator 5V_PROX_REGULATOR. The diode D2 has an anode terminal connected to the other end of the resistor R4, and a cathode terminal connected to an on/off terminal of the regulator 5V_PROX_REGULATOR. The BJT Q3 has a collector terminal connected to the on/off terminal of the regulator 5V_PROX_REGULATOR1, and an emitter terminal that is grounded. The resistor R6 has one end connected to base terminal of the BJT Q3, and the other end connected to a voltage terminal Prox_Wakeup through which a voltage of a wake-up signal is outputted. The resistor R7 has one end connected to the voltage terminal Prox_Wakeup through which a voltage of the wake-up signal is outputted, and the other end that is grounded.

Operation of each elements of the circuit diagram of Fig. 5 will be described with reference to Fig. 6 in detail.

Fig. 6 is an operation flowchart of the connection detecting device for the electric vehicle charger according to another embodiment.

In operation S301, the battery (not shown) supplies the DC voltage. Here, the DC voltage supplied from the battery has a lower level than the DC voltage supplied from the regulator 5V_PROX_REGULATOR1 of the power supply unit 353. The DC voltage supplied from the battery is outputted through the voltage terminal V_Battery.

In operation S303, when the vehicle charger 330 is connected to the electric vehicle 350, the wake-up signal generation unit 358 generates the wake-up signal. When the vehicle charger 330 is connected to the electric vehicle 350, the regulator 5V_PROX_REGULATOR1 is not turned on, and thus a voltage is not outputted from the voltage terminal 5V_Prox. Thus, the BJT Q1 and the BJT Q2 are turned off. Therefore, the BJT Q1, the resistor R5, the LED and the resistor R10 of the optoisolator OP constitute an open circuit. That is, the wake-up signal generation unit 358 is open-circuited, so that a current does not flow.

When the vehicle charger 330 is connected to the electric vehicle 350, the BJT Q1, the resistor R5, the LED of the optoisolator OP, the resistor R10, the resistor R11, and the resistor R14 constitutes a closed circuit. Thus, a current flows through the LED of the optoisolator OP, and the photo transistor of the optoisolator OP is turned on. Therefore, the voltage supplied from the voltage terminal V_Battery is applied to the ends of the resistor R1 and the resistor R9. The voltage applied to the one end of the resistor R9 is inputted to the voltage terminal Prox_Wakeup as the wake-up signal.

The power supply unit 353 receives the wake-up signal to be turned on. In detail, in operation S305, the power supply unit 353 receives the wake-up signal to turn the regulator 5V_PROX_REGULATOR1 on. In detail, when the power supply unit 353 receives the wake-up signal, a voltage as the wake-up signal is outputted to the voltage terminal Prox_Wakeup. Here, the wake-up signal passes through the diode D1 to turn the regulator 5V_PROX_REGULATOR1 on.

In operation S307, the power supply unit 353 supplies the voltage to the charging coupler 331 through the regulator 5V_PROX_REGULATOR1. When the regulator 5V_PROX_REGULATOR1 is turned on, the voltage is outputted from the voltage terminal 5V_Prox. Thus, the voltage is supplied to the base terminal of the BJT Q2 to turn on the BJT Q2 and ground the base terminal of the BJT Q1. Thus, the BJT Q1 is turned off. Also, the voltage is supplied to the base terminal of the BJT Q4 to turn on the BJT Q4. The voltage terminal 5V_Prox, the resistors R10, R12, R11, and R14 constitute a closed circuit. Here, a voltage is applied to the resistors R10, R12, R11, and R14.

In operation S309, the connection detecting unit 355 detects the voltage of the connection unit 351 through the voltage sensor 356. In detail, the voltage sensor 356 detects the voltage applied to the one end of the resistor R12.

The control unit 359 may determine whether the electric vehicle 350 is connected to the vehicle charger 330 on the basis of a level of the detected voltage. In detail, this procedure will be performed as described below.

In operation S311, the control unit 359 determines whether the level of the detected voltage is greater than that of the first reference voltage.

In operation S313, when the level of the detected voltage is greater that that of the first reference voltage, the control unit 359 determines that the electric vehicle 350 is connected to the vehicle charger 330.

In operation S319, the connection detecting unit 355 detects the voltage of the connection unit 351 through the voltage sensor 356. In detail, the voltage sensor 356 detects the voltage applied into the one end of the resistor R12. Here, the level of the voltage is the same as follows: (resistance of resistor R121 || (resistance of resistor R11+resistance of resistor R14)/((resistance of resistor R10+resistance of resistor R12) || (resistance of resistor R11+resistance of resistor R14)) X an output voltage of voltage terminal 5V_Prox.

In operation S313, the control unit 359 determines that the electric vehicle 350 is connected to the vehicle charger 330. Here, the control unit 359 may perform an operation for charging the electric vehicle 350. In detail, the control unit 359 may activate the charging device in the electric vehicle 350.

In operation S315, the connection detecting unit 355 detects a voltage of the connection unit 351 through the voltage sensor 356.

In operation S317, the control unit 359 determines whether the level of the detected voltage is greater than that of the second reference voltage.

When the intensity of the detected voltage is greater that that of the second reference voltage, the control unit 359 determines that the electric vehicle 350 is disconnected from the vehicle charger 330. When the vehicle charger 330 is disconnected from the electric vehicle 350, the voltage outputted from the voltage terminal 5V_Prox is divided into the resistor R10 and the resistor R12. Here, the resistance of the resistor R12 is greater than that of a parallel-combined resistor in which the resistor R12 is parallelly connected to a serial-combined resistor of the resistor R14 and the resistor R11. Thus, the voltage applied to the resistor R12 increases. Thus, the second reference voltage is greater than the first reference voltage.

In operation S321, the control unit 359 generates a sleep signal to input the sleep signal to a voltage terminal Prox_Sleep.

The power supply unit 353 turns off the regulator 5V_PROX_REGULATOR1. In detail, in operations S323 and S325, the power supply unit 353 receives the sleep signal to turn off the regulator 5V_PROX_REGULATOR1 and thus stop supplying of the voltage to the charging coupler 331. When the voltage is outputted from the voltage terminal Prox_Sleep, the BJT Q3 is turned on. Thus, the on/off terminal of the regulator 5V_PROX_REGULATOR1 is grounded. Therefore, the regulator 5V_PROX_REGULATOR1 is turned off.

Since the device 300 of detecting connection of the charger for the electric vehicle according to another embodiment is in an open-circuit state before the vehicle charger 330 is connected, power consumption may be avoided in an ideal circuit. Also, even in a non-ideal circuit in which power consumption inevitably occurs, the device 300 of detecting connection of the charger for the electric vehicle according to another embodiment may minimize power consumption.

Also, the optoisolator OP is used to prevent the electric connection from occurring, thereby minimizing the power loss.

Therefore, the device 300 of detecting connection of the charger for the electric vehicle according to another embodiment may minimize the power consumption that is required to detect the connection of the charger.

The present disclosure provides the connection detecting device for the electric vehicle charger, which detects connection between the vehicle charger and the charging coupler. In particular, the present disclosure provides the connection detecting device for the electric vehicle charger, which detects connection between the vehicle charger and the charging coupler and minimize the power loss.

A particular feature, structure, or effects described in connection with the embodiment is included in at least one embodiment of the invention, and is not limited to only one embodiment. Further, when a particular feature, structure, or characteristic is described in connection with any embodiment, it is submitted that it is within the purview of one skilled in the art to effect such feature, structure, or characteristic in connection with other ones of the embodiments. Therefore, contents with respect to various variations and modifications will be construed as being included in the scope of the present disclosure.

Although embodiments have been described with reference to a number of illustrative embodiments thereof, it should be understood that numerous other modifications and embodiments can be devised by those skilled in the art that will fall within the spirit and scope of the principles of this disclosure. More particularly, various variations and modifications are possible in the component parts and/or arrangements of the subject combination arrangement within the scope of the disclosure, the drawings and the appended claims. Therefore, contents with respect to various variations and modifications will be construed as being included in the scope of the present disclosure.

## Claims

1. A connection detecting device (300) for an electric vehicle charger (330), which detects whether the vehicle charger (330) is connected to the electric vehicle (350), the connection detecting device comprising:
a connection unit (351) connecting a coupler (331) of the vehicle charger (330) to the electric vehicle (350);
a power supply unit (353) supplying a voltage to the connection unit (351) when being turned on;
a first signal generation unit (358) generating a first signal to turn on the power supply unit (353) when the vehicle charger (330) is connected to the electric vehicle (350); and
a control unit (359) determining whether the vehicle charger (330) is connected to the electric vehicle (350) on the basis of the voltage applied to the connection unit (351),
wherein the first signal generation unit (358) is an open circuit through which a current does not flow, when the vehicle charger (330) is disconnected from the electric vehicle (350).

2. The connection detecting device (300) according to claim 1, wherein the first signal generation unit (358) comprises an optoisolator, and
when the vehicle charger (330) is connected to the electric vehicle (350), the first signal generation unit (358) allows the current to flow into a light emitting diode (LED) of the optoisolator to generate the first signal.

3. The connection detecting device (300) according to claim 1, wherein, when the voltage applied into the connection unit (351) has a higher level than a first reference voltage, the control unit (359) determines that the vehicle charger (330) is connected to the electric vehicle (350).

4. The connection detecting device (300) according to claim 3, wherein the control unit (359) determines whether the vehicle charger (330) is disconnected from the electric vehicle (350) on the basis of the voltage applied to the connection unit (351), and
wherein the device further comprises a signal generation unit generating a second signal to turn off the power supply unit (353) when the vehicle charger (330) is disconnected from the electric vehicle (350).

5. The connection detecting device (300) according to claim 4, wherein, when the voltage applied to the connection unit (351) has a higher level than the second reference voltage, the control unit (359) determines that the vehicle charger (330) is disconnected from the electric vehicle (350),
the second reference voltage being greater than the first reference voltage.

6. The connection detecting device (300) according to claim 1, wherein the connection unit (351) comprises:
a first resistor (R12) to which one end of the vehicle charger (330) is connected;
a junction-type transistor (Q4) having a collector terminal connected to the other end of the first resistor (R12), and an emitter terminal that is grounded;
a second resistor (R10) having one end connected to the one end of the first resistor (R12), and the other end connected to the first signal generation unit (358).

7. The connection detecting device (300) according to claim 6, wherein when the power supply unit (353) is turned on, the junction-type transistor (Q4) is turned on.

8. A method of operating a connection detecting device (300) for an electric vehicle (350) charger (330), which detects whether the vehicle charger (330) is connected to the electric vehicle (350), the method comprising:
determining whether the vehicle charger (330) is connected to the electric vehicle (350) on the basis of a voltage applied to a connection unit (351) which connects a coupler (331) of the vehicle charger (330) to the electric vehicle (350); and
generating a first signal through a first signal generation unit (358) to turn on a power supply unit (353) for supplying the voltage to the connection unit (351), when the vehicle charger (330) is connected to the electric vehicle (350),
wherein the first signal generation unit (358) is an open circuit in which a current does not flow when the vehicle charger (330) is disconnected from the electric vehicle (350).

9. The method according to claim 8, wherein the first signal generation unit (358) comprises an optoisolator, and
the turning on of the power supply unit (353) comprises:
allowing the current to flow into the LED of the optoisolator to generate the first signal when the vehicle charger (330) is connected to the electric vehicle (350).

10. The method according to claim 9, wherein the determining of whether the vehicle charger (330) is connected to the electric vehicle (350) comprises:
determining that the vehicle charger (330) is connected to the electric vehicle (350) when the voltage applied to the connection unit (351) has a higher level than a first reference voltage.

11. The method according to claim 10, further comprising:
determining whether the vehicle charger (330) is disconnected from the electric vehicle (350) on the basis of the voltage applied to the connection unit (351); and
generating a second signal through a second signal generation unit (356) to turn off the power supply unit (353) when the vehicle charger (330) is disconnected from the electric vehicle (350).

12. The method according to claim 11, wherein the determining of whether the vehicle charger (330) is disconnected from the electric vehicle (350) comprises:
determining that the vehicle charger (330) is disconnected from the electric vehicle (350) when the voltage applied to the connection unit (351) has a higher level than the second reference voltage,
wherein the second reference voltage is greater than the first reference voltage.
